# EUROPEAN PATENT APPLICATION

(11) **EP 1 849 889 A1**
(43) Date of publication of application: **31.10.2007**
(21) Application number: 07106956.1
(22) Date of filing: 25.04.2007
(51) Int. Cl.: C23C 16/04, C23C 16/46

(54) **Process furnace or the like**

(30) Priority: 25.04.2006 FR 0651455
(71) Applicant: MESSIER-BUGATTI, 78140 Velizy, Villacoublay (FR)
(72) Inventor: Lanvin, Laurent, 69740 Genas (FR); Jouannard, Philippe, 31240 Saint-Jean (FR)
(74) Representative: Joly, Jean-Jacques

(57) **Abstract**

A part of a CVI/CVD furnace, in which a heating system (22) for heating the furnace is located, is isolated from a remaining part of the furnace exposed to a reactive gas present therein. The shell of the furnace may for example be provided with a dividing wall (16) or the like to provide a physical separation. In addition, an inert gas such as argon or nitrogen is supplied through conduit (34) to the heating zone containing the heating system so that part of the furnace is at positive pressure differential compared to the part in which the reactive gas is present. As a result, the reactive gas is retarded from contacting the heating system which could, among other things, cause deposits to form thereon. More generally, the control of reactive gas flow in the furnace is better controlled.

## Description

### Field of the invention:

The present invention most generally relates to ovens, furnaces, process chambers and the like into which a reactive gas is as part of a process step. A particular example of the invention relates to furnaces for chemical vapor inflitration/chemical vapor deposition (CVI/CVD) into which a reactive gas is introduced as part of a process of densifying porous elements, such as porous brake preforms.

### Background of the invention:

The use of ovens, furnaces, process chambers, and the like into which a reactive gas is introduced as part of a process step is generally known. (Hereinafter, the mention of "furnace" in the description should be understood to be equally applicable to ovens and other process chambers of this nature, generally.) An example in this regard is the process of chemical vapor infiltration, in which a precursor reactive gas is introduced into a furnace in which porous elements (such as, for example and without limitation, porous brake disk preforms) are placed.

Generally, a conventional furnace includes an outermost furnace shell, a working space or reaction chamber provided therein into which objects or elements to be processed are placed, a system for moving the reactive gas into and out of the furnace, and a heating system for heating at least an interior of the reaction chamber.

The reactive gas is caused, in a known manner, to infiltrate the porous structure of the porous elements. The reactive gas can be a hydrocarbon gas, such as propane.

In one known example, a reactive gas is introduced into an interior volume defined by a stack of substantially aligned annular brake disk preforms placed in the reaction chamber in a furnace. In general, the gas is caused to move from the interior volume of the stack to the exterior of the stack by diffusing through the porous (e.g., fibrous) structure of the preforms and/or through gaps between adjacent preforms.

At least the interior of the reaction chamber is heated by the heating system. Thus, because of the relatively high temperature of the brake disk preforms, the reactive gas pyrolizes and leaves a decomposition product on the interior surfaces of the porous structure. In the case of a hydrocarbon gas, for example, the decomposition product is pyrolytic carbon, so that a carbon composite material (such as carbon-carbon) is obtained.

An example of a conventional heating system for such furnaces is an inductive heating system. In such as system, the reaction chamber may be made from a material so as to act as a susceptor, such as graphite. A system for providing the requisite magnetic field, such as one or more electrical coils placed operatively adjacent at least part of the susceptor is also provided. When a sufficient alternating current is applied to the electrical coils, the resultant magnetic field causes inductive heating of the susceptor in a well-known manner.

Another conventional heating system is resistive heating, in which an electrical current is passed through a resistive element, which is heated as a result. The use of resistive heating usually entails the use of a resistive element in addition to the structure defining the reaction chamber.

With both inductive and resistive heating systems, thermal insulation may be provided about an exterior of the reaction chamber in order to increase heating efficiency.

However, the reactive gas introduced into the reaction chamber can tend to leak or diffuse out of the reaction chamber into the volume within the furnace but outside of the reaction chamber.

In particular, in a CVI/CVD process, the reactive gas is usually a precursor gas for a decomposition product to be deposited (such as a carbide or carbon deposit). If the reactive gas reaches the insulation or the heating system, a buildup of the deposit can build up on those structures, which causes deterioration in function, reliability, and/or operational lifespan.

### Brief description of the invention:

In view of the foregoing, it is desirable to substantially isolate the heating system (and associated thermal insulation, if any) in a CVI/CVD furnace from a reactive gas being used therein.

Therefore, the present invention contemplates defining a zone in a CVI/CVD furnace shell in which the heating system (including associated thermal insulation, if any) is substantially isolated from contact with the reactive gas being used in the CVI/CVD process.

In one respect, the isolated zone (sometimes referred to herein as the "heating zone") in the furnace shell is physically separated by a wall structure located within the furnace shell to define the heating zone.

In an additional respect, the present invention contemplates introducing a flow of an inert gas into the heating zone so as to define a slight positive pressure differential relative to the pressure of the reactive gas within the reaction chamber. This pressure differential further retards any tendency for the reactive gas to enter the heating zone.

The present invention can be even better understood with reference to the appended figures, in which:
Figure 1 is a cross-sectional schematic view of a process furnace according to the present invention in which an inductive heating system is used; and
Figure 2 is a partial cross-sectional view illustrating the alternative use of a resistive heating system within the present invention as contemplated,

### Detailed description of the present invention:

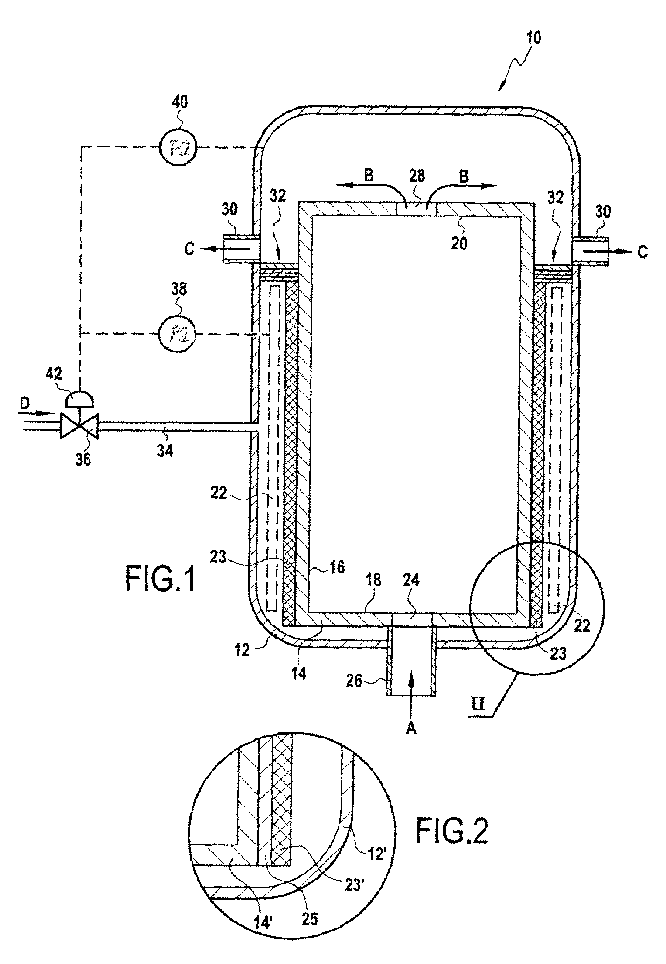

To simplify the description of the invention, an example of an inductively heated furnace will first be set forth. Thereafter, with reference to Figure 2, the applicability of the present invention to a furnace using resistive heating will be illustrated.

In general, a furnace 10 used for CVI/CVD comprises an outer furnace shell 12 separating an interior of the furnace 10 from the exterior and defining a certain volume therein.

Within the volume of the furnace 10, a susceptor 14 is provided. As is well-known in the art, a susceptor is generally a structure that becomes heated in the presence of a magnetic field generated by an alternating current. Susceptor 14 in a CVI/CVD furnace may, for example, comprise one or more walls 16, a floor 18, and a top 20 that collectively define another volume or reaction chamber within the overall volume within the furnace 10. Objects to be treated, such as porous brake disk preforms are placed in the volume 21 defined by the susceptor 14.

A system for heating the furnace is generically illustrated at 22. For example, in the case of an inductively heated furnace, the heating system 22 is one or more conventional electrical coils connected to an exterior electrical supply of appropriate power. Electrical coils of this nature are considered to be known to one skilled in the art and are therefore not described in detail nor illustrated here.

In order to increase efficiency of heating the susceptor 14, thermal insulation 23 may be provided on an exterior of one or more surfaces of susceptor 14. The thermal insulation is conventional in the art, such as ceramic-based thermal insulation material, or carbon fiber insulation, especially carbon fibers forming successively stacked layers.

One or more gas inlet passages 24 are provided in the susceptor 14. (One gas inlet passage 24 is illustrated in Figure 1 for the sake of illustrative simplicity.) The reactive gas (for example, a hydrocarbon gas) is introduced into the furnace 10 by way of a conduit 26 that crosses the furnace wall 12 from the exterior. The conduit 26 is at least aligned with gas inlet passage 24 and may be fixed thereto or in relation thereto by any suitable method, such as bolts or by welding. Most generally, it is preferable that there be little or no leakage of reactive gas at the interface between conduit 26 and susceptor 14. The reactive gas flow through conduit 26 is suggested by the arrow labeled A in Figure 1.

Generally, the reactive gas is exhausted (by conventional gas moving methods, such as fans, suction blowers, etc. but not illustrated) or otherwise exits from the working space by way of one or more gas outlet passages 28, as suggested by the arrows labeled B. The reactive gas then exits or is caused to exit the furnace 10 by way of one or more furnace outlets 30, as generally indicated by the arrows labeled C.

According to an example of the present invention the interior volume of the furnace defined by shell 12 may be partitioned so as to define the above-mentioned heating zone. For example, as seen in Figure 1, an annular "plank" or wall 32 is provided and extends radially between an interior surface of shell 12 and an exterior surface of susceptor 14. The wall 32 is fixed in place by any conventional fixation method suitable for the operative environment within the furnace 10. More particularly, the wall 32 is sealed (for example, by welding, or the provision of physical sealing members) at both its radially inner and outer edges so as to have a substantially total gas seal against the passage of a gas thereby. The wall 32 may desirably comprise an assembly of layers, such as a stack of rigid and/or flexible ceramic layers.

An inert gas, such as argon or nitrogen, is supplied to the heating zone by way of an inert gas supply conduit 34, as suggested by the arrow labeled D in Figure 1.

The flow D of inert gas can be regulated by a conventional valve 36. With a given regulation of valve 36, a gas flow D can be obtained that maintains a predetermined pressure P1 in the heating zone (as detected by schematically illustrated pressure detector 38).

In parallel, the pressure P2 in the other part of the volume defined within furnace shell 32 in which the reactive gas is present (sometimes referred to herein as the reactive zone) is detected by another pressure detector 40.

The detected pressures P1 and P2 may be provided together to a valve controller 42 (preferably, an automatic valve controller) so that the inert gas flow D maintains a particular positive pressure differential in the heating zone with respect to the remainder of the volume in furnace shell 10. For example, the pressure differential to be maintained may be about +0.5 to about +5 millibars in favor of the heating zone, and more specifically, about +1 to about +2 millibars in favor of the heating zone. This slight overpressure in the heating zone also retards any leakage or other entry of the reactive gas into the heating zone.

As mentioned above, the determination of the pressures P1 and P2 may be beneficially automatic. For example, the pressure difference between the pressures detected by each detector 38, 40 could be automatically calculated at regular intervals and provided to valve controller 42. This result can then be used to automatically adjust the flow D of inert gas into the heating zone.

It will be appreciated that the inert gas flow could also be monitored, such that an unusually high consumption of inert gas in order to maintain a given pressure in the heating zone could be taken as an indication of a gas leak in the integrity of the heating zone, particularly at the wall 32. This determination could be used to trigger a user perceivable alarm, or could be used as a control system trigger signal for automatically triggering a responsive procedure.

The application of the present invention to a furnace heated instead by a resistive heating system is not substantially different that for an inductively heated furnace. Figure 2 is a partial cross-sectional view illustrating an example of how the elements in a resistive heating system are arranged, but fundamentally, the same concepts apply as those explained above. Namely, a portion of the volume defined by furnace shell 12' in which the resistive heating system is disposed is gas-sealingly separated from the remainder of the volume within furnace shell 12' where the reactive gas is present. A reaction chamber 14' is disposed within the furnace shell 12', in which objects to be processed are placed. One or more resistive elements 25 can then be placed in contact with or at least adjacent to an exterior of the reaction chamber 14'. The resistive elements 25 can have a variety of conventional configurations. In one typical example, the resistive elements are elongate members.

As in the inductively heated furnace, a layer of thermal insulation 23' may be provided to increase the heating efficiency of the furnace.

Notwithstanding the different arrangement of the heating system when resistance heating is used, however, the same overall configuration within furnace shell 12' applies as in the inductively heated furnace. Namely, the elements of the resistive heating system are similarly isolated from a part of the furnace containing the reactive gas, so a description of the arrangement of a separating wall and the inert gas system is not repeated.

Although the present invention has been described above with reference to certain particular examples for the purpose of illustrating and explaining the invention, it is to be understood that the invention is not limited solely by reference to the specific details of those examples. More specifically, a person skilled in the art will readily appreciate that modifications and developments can be made in the preferred embodiments without departing from the scope of the invention as defined in the accompanying claims.

## Claims

1. A CVI/CVD furnace comprising:
an outermost furnace shell defining a first volume within the furnace;
a reaction chamber disposed the furnace shell, into which an element to be processed by the furnace is placed;
a heating system for heating at least the reaction chamber; and
a reactive gas circulation system for introducing a reactive gas into the reaction chamber from an exterior of the furnace shell and for conveying the reactive gas out of the reaction chamber to the exterior of the furnace shell;
**characterized in that**:
a portion of the first volume in which the heating system is located is isolated in a substantially gas-sealed manner from a reactive zone in the first volume in which the reactive gas is present, thereby defining a heating zone; and
**in that** the furnace further comprises an inert gas circulation system constructed and arranged to supply an inert gas to the heating zone at a rate which creates a positive pressure differential with respect to a pressure within the remainder of the first volume in which the reactive gas is present, so as to retard a flow of reactive gas into the heating zone.

2. The furnace of claim 1, **characterized in that** it comprises a heating zone pressure detector constructed and arranged to determine a pressure within the heating zone, wherein the inert gas circulation system comprises a flow regulator, the flow regulator being operable in correspondence with the detected pressure within the heating zone so as to set an inert gas flow rate that results in a predetermined pressure within the heating zone.

3. The furnace of claim 2, **characterized in that** it further comprises a reactive zone pressure detector constructed and arranged to determine a pressure within the reactive zone where reactive gas is present, wherein the flow regulator of the inert gas circulation system is constructed and arranged to control the flow of inert gas into the heating zone at least partly based on the detected pressure within the reactive zone, so as to obtain a predetermined positive pressure differential between the heating zone and the reactive zone.

4. The furnace of any one of claims 1 to 3, **characterized in that** it further comprises an alarm for signaling a change in the flow of inert gas needed to maintain a given pressure within the heating zone.

5. The furnace of any one of claims 1 to 4, wherein the heating system is an inductive heating system.

6. The furnace of any one of claims 1 to 4, wherein the heating system is a resistive heating system.

7. The furnace of any one of claims 1 to 6, wherein the reaction chamber comprises one or more of a wall member, a floor member, and a top member.

8. The furnace of claim 7, comprising a reactive gas inlet conduit arranged to convey a reactive gas from an exterior of the furnace shell to a reactive gas inlet opening formed in the reaction chamber.

9. The furnace of claim 7 or claim 8, comprising a reactive gas outlet opening in the reaction chamber.

10. The furnace of claim 9, comprising a reactive gas outlet provided in the furnace shell.

11. The furnace according to claim 2 or claim 3, **characterized in that** it further comprises a controller for automatically controlling the flow regulator based on one or both of the detected pressure of the heating zone and the pressure of the reactive zone.

12. The furnace according to claim 1, comprising a barrier wall for dividing the heating zone from the reactive zone, the barrier wall including at least one ceramic layer.
